# EUROPEAN PATENT APPLICATION

(11) **EP 4 759 640 A1**
(43) Date of publication of application: **17.06.2026**
(21) Application number: 25221834.2
(22) Date of filing: 09.12.2025
(51) Int. Cl.: B60R 21/017, F42D 1/05, F42C 11/00

(54) **DEPLOYMENT CIRCUIT FOR A PYROTECHNIC DEVICE, CORRESPONDING INTEGRATED CIRCUIT, VEHICLE AND METHOD**

(30) Priority: 11.12.2024 IT 202400028191
(71) Applicant: STMicroelectronics International N.V., 1228 Plan-les-Ouates, Genève (CH)
(72) Inventor: D'ANGELO, Vittorio, 84015 Nocera Superiore (IT); PELLEGRINI, Mauro Jonathan, 20091 Bresso (MI) (IT); PEDONE, Leonardo, 62012 Civitanova Marche (IT); GIORDANO, Antonio, 20148 Milano (IT); CANNAVACCIUOLO, Salvatore, 80010 Villaricca (NA) (IT)
(74) Representative: Buzzi, Notaro & Antonielli d'Oulx S.p.A.

(57) **Abstract**

A deployment circuit (20) for a pyrotechnic device (101) is disclosed. The deployment circuit (20) comprises a first terminal (122a) and a second terminal (122b) configured to be connected to the pyrotechnic device (101). A driver circuit (200) comprises at least one electronic switch (2002a) configured to selectively connect the first terminal (122a) and the second terminal (122b) to a supply voltage (V_{IN}) in response to determining that a deployment control signal (DEP_CMD) is asserted. A current limiter (2000a) limits the current (I_{PYRO}) provided via the first terminal (122a) and the second terminal (122b) to a maximum value (IMAX). A control circuit (202) drives the driver circuit (200) as a function of a fire request signal (REQ).

Specifically, when the fire request signal (REQ) is de-asserted, the control circuit determines (1004) whether a first value (MR) indicative of a resistance (R_{PYRO}) between the first terminal (122a) and the second terminal (122b) is between a first threshold and a second threshold. In response to determining that the first value (MR) is not between the first threshold and the second threshold, the control circuit signal (1016) an error.

Conversely, when the fire request signal (REQ) is asserted, the control circuit starts (1006) a deployment cycle by asserting the deployment control signal (DEP_CMD), and stops (1010) the deployment cycle after a given time-period (t_{DC}) by de-asserting the deployment control signal (DEP_CMD). The control circuit monitors (1008) during the deployment cycle a value (CNT) indicative of the time (t_{DEPLOY}) where the current (I_{PYRO}) provided via the first terminal (122a) and the second terminal (122b) is greater than a current threshold (I_{TH}). Moreover, once the deployment cycle has been stopped, the control circuit obtains (1012) a second value (MR) indicative of the resistance (R_{PYRO}) between the first terminal (122a) and the second terminal (122b), and determines (1014) whether the monitored value (CNT) indicates that the time (t_{DEPLOY}) is greater than a time threshold (t_{TH}) and whether the second value (MR) is greater than a third threshold. Specifically, when both conditions are satisfied, the control circuit signals (1020) a correct deployment of the pyrotechnic device (101).

## Description

### Technical field

The present disclosure relates to circuits for deploying an electrically activated pyrotechnic device, such as a squib, a pyro-fuse or a pyro-actuator, and corresponding methods.

### Technological background

Electrically activated pyrotechnic devices serve as indispensable components for delivering substantial amounts of energy within extremely brief deployment windows and, for this reason, are widespread in safety applications. Notably, this category includes squibs utilized for airbag activation, pyro-fuses designed to swiftly disconnect electrical connections, such as, for example, a connection of an electric vehicle (EV) battery in the event of a short to ground fault, and pyro-actuators.

In the context of safety applications, various solutions have been proposed for monitoring the correct connection of the pyrotechnic device to the deployment circuit. For example, such solutions are disclosed in United States Patent Application Publications nos. US 2018/0029554 A1 and US 2019/0302162 Al. Substantially, such solutions are based on the fact that the pyrotechnic device usually has a resistance value being in a given tolerance range. Accordingly, by determining whether the resistance value between the terminals connected to the pyrotechnic device are between a lower threshold value and an upper threshold value, the deployment circuit may determine whether the pyrotechnic device is correctly connected to the deployment circuit.

Conversely, the actual deployment of the pyrotechnic device is usually detected via auxiliary sensors. For example, such a solution is disclosed by United States Patent Publication no. US 10,029,640 B2 or JP 1002/144994 A in the context of a deployment detection of an airbag.

Moreover, Italian Patent Application IT 102024000002019, filed on February 1, 2024, discloses solutions for detecting the deployment of the pyrotechnic device by monitoring the voltage at the terminals of the pyrotechnic device.

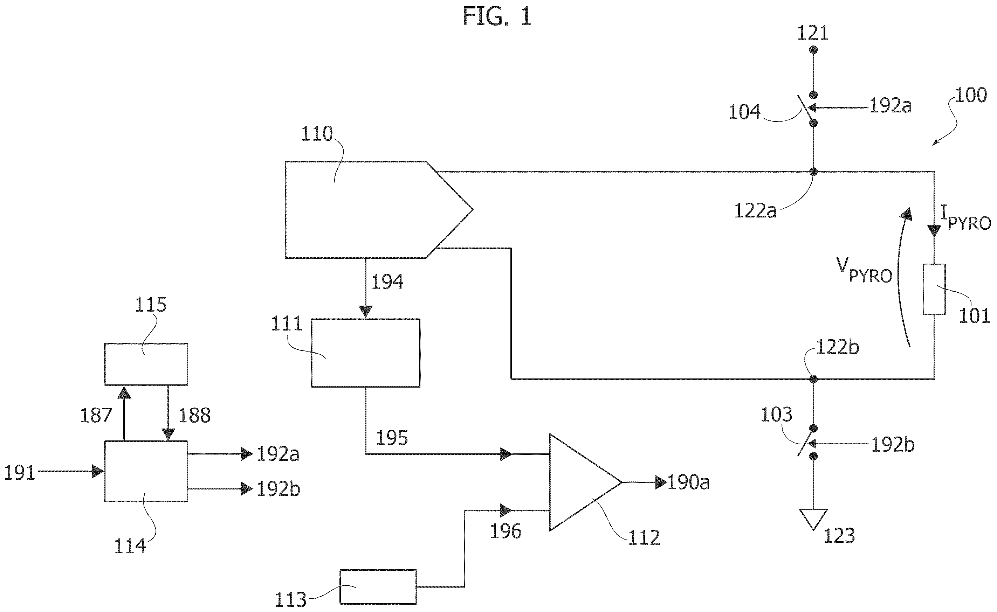

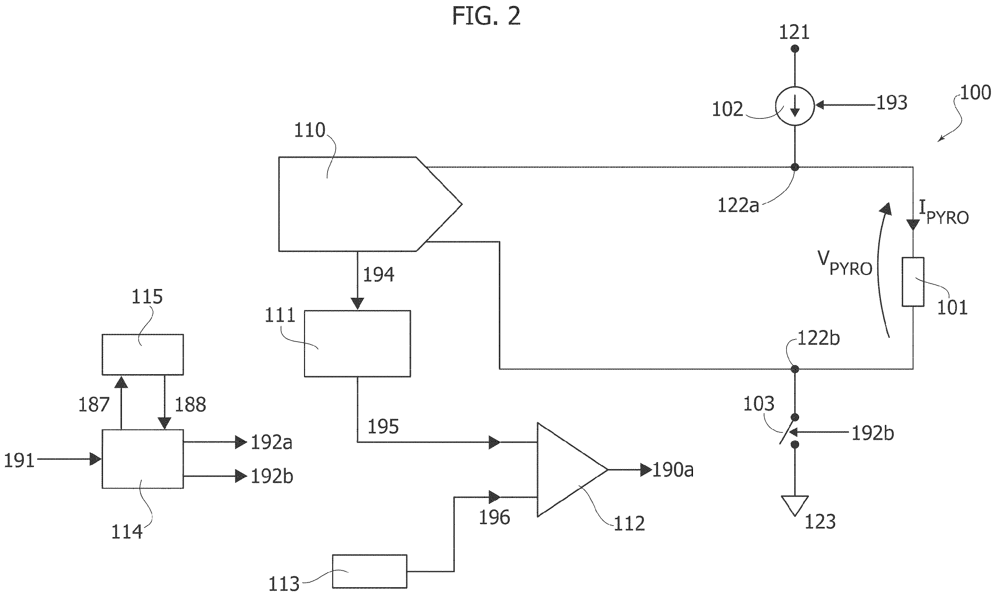

For example, Figure 1 and 2 show exemplary deployment circuits 100. The deployment circuit 100 comprises a first terminal 122a and a second terminal 122b configured to be connected to an electrically activated pyrotechnic device 101. For example, the pyrotechnic device 101 may be an airbag squib, a seat belt pretensioner initiator, a pyro-switch or a pyro-fuse.

Moreover, the deployment circuit 100 comprises a driver circuit configured to selectively energize the pyrotechnic device 101. Typically, the driver circuit is configured to apply a given voltage V_{PYRO} to the terminals 122a and 122b or control a current I_{PYRO} provided via the terminals 122a and 122b. In fact, from an electrical point of view, a pyrotechnic device 101 to be fired represents mainly a resistive load.

For example, in Figure 1, the driver circuit is configured to selectively connect the terminals 122a and 122b to a supply voltage V_{IN}. For this purpose, the driver circuit may comprise a first terminal 121 and a second terminal 123, e.g., representing a ground GND, configured to receive the supply voltage V_{IN}. For example, the voltage V_{IN} may be provided by a battery, e.g., of a vehicle comprising the pyrotechnic device 101, e.g., associated with respective airbags of the vehicle. Alternatively, the supply voltage V_{IN} may be provided by one or more capacitances (not shown in Figure 1). For example, such capacitance(s) may be charged by an additional electronic converter, such as a step-up or step-down converter.

For example, in Figure 1, the driver circuit comprises a first electronic switch 104 configured to connect the terminal 122a to the terminal 121 as a function of a first drive signal 192a and/or a second electronic switch 103 configured to connect the terminal 122b to the terminal 123 as a function of a second drive signal 192b. For example, the switches 103 and 104 may be Field-Effect Transistors (FET), such as Metal-Oxide-Semiconductor Field-Effect Transistors (MOSFET). For example, each switch 103 and 104 may be a normally open switch, such as a depletion mode MOSFET, which is closed in response to the reception of an asserted driving signal (192b or 192a).

Accordingly, when the terminals 122a and 122b are connected to the supply voltage, e.g., when the electronic switches 103 and 104 are closed, the voltage V_{IN} is also applied to the pyrotechnic device 101 (neglecting possible parasitic resistances, e.g., of cables), i.e., the voltage V_{PYRO} at the pyrotechnic device 101 correspond to the voltage V_{IN}, whereby a current I_{PYRO} flows through the pyrotechnic device 101.

Conversely, in Figure 2, the driver circuit is configured to selectively apply a current to the terminals 122a and 122b. For example, in the embodiment considered, the driver circuit comprises a current source or current limiter 102 configured to set or limit, respectively, the current provided via the terminals the terminals 122a and 122b.

For example, in Figure 2, the driver circuit comprises a current source or current limiter 102 connected between the terminal 122a and the terminal 121. The current source or current limiter 102 may be configured to set the requested current or the maximum current, respectively, as a function of a reference signal 193. For example, the circuit 102 may be implemented with a field effect transistor (FET). For example, this FET may correspond to the output stage of a current mirror.

In this case, the driver circuit may also comprise the first electronic switch 104 and/or the second electronic switch 103 shown in Figure 1. For example, in Figure 2, the driver circuit comprises the electronic switch 103 configured to connect the terminal 122b to the terminal 123 as a function of a second drive signal 192b. Accordingly, in Figure 2, the driver circuit is configured to regulate or at least limit the current I_{PYRO} flowing through the pyrotechnic device 101.

For example, a current source 102 may be implemented by measuring the current I_{PYRO}, such as the current flowing through the electronic switch 104 and/or 103 (see Figure 1), wherein the driver circuit comprises a closed loop control circuit configured to regulate the measured current to a requested value by selectively connecting the terminals 122a and 122b to the voltage V_{IN} or disconnecting the terminals 122a and 122b from the voltage V_{IN}, e.g., via the electronic switches 104 and 103.

Conversely, the driver circuit may implement a current limiter 102 by connecting the terminals 122a and 122b to the voltage V_{IN} when the measured current I_{PYRO} is smaller than the maximum request value, and disconnecting the terminals 122a and 122b from the voltage V_{IN} when the measured current I_{PYRO} is greater than the maximum request value. In various embodiments, the comparison may also comprise a hysteresis, i.e., the driver circuit may be configured to disconnect the terminals 122a and 122b from the voltage V_{IN} when the measured current I_{PYRO} is greater than the maximum request value, and connect the terminals 122a and 122b to the voltage V_{IN} when the measured current I_{PYRO} is smaller than a minimum request value.

Accordingly, the deployment circuit 100 comprises also a control circuit 114 configured to generate one or more of the signals 192a, 192b and 193 as a function of a fire or deployment request signal 191. For example, the signal 191 may be generated by an external deployment control circuit.

For example, with respect to the circuit shown in Figure 1, in response to detecting that the deployment request signal 191 indicates a request to fire, e.g., when the signal 191 is asserted, the control circuit 114 asserts the (high-side) driving signal 192a and the (low-side) driving signal 192b.

Conversely, with respect to the circuit shown in Figure 2, in response to detecting that the deployment request signal 191 indicates a request to fire, e.g., when the signal 191 is asserted, the control circuit 114 asserts the (low-side) driving signal 192b. In case the current source or limiter 102 is configurable, the control circuit 114 may also generate the signal 193 in order to set the current I_{PYRO} to a given requested value or limit the current I_{PYRO} to a given maximum value. Alternatively, the control circuit 114 may be configured to measure the current I_{PYRO}, and drive the electronic switches 103 and/or 104 as a function of the measured current, e.g., by implementing a closed loop control of the current I_{PYRO}, or a comparison with one or more threshold values, such as a maximum and minimum current.

Specifically, according to document IT102024000002019, the deployment circuit comprises a processing circuit 111 configured to receive the voltage at the terminals 122a and 122b, i.e., the voltage V_{PYRO} across the pyrotechnic device 101, and generate a processed signal 195. The processing circuit 111 may be any analog and/or digital circuit. For example, in Figure 1 is shown an analog-to-digital converter (ADC) 110, connected between the processing circuit 111 and the terminals 122a and 122b of the pyrotechnic device 101.

Moreover, a comparator 112 is configured to generate a deployment status signal 190a by comparing the (analog or digital) processed signal 195 with a threshold 196. For example, in response to determining that the processed signal 195 is greater than the (analog or digital) threshold 196, the comparator 112 may assert the deployment status signal 190a, e.g., set the signal 190a to high. Document IT102024000002019 proposes various processing operations, which may be implemented with the processing circuit 111. For example, the signal 195 may be indicative of the specific energy for unit resistance, i²t, supplied to the pyrotechnic device 101 and may be, for instance, a resistance, a voltage or a specific energy per unit resistance.

Specifically, as shown in Figure 1, the control circuit 114 may be coupled to a timer circuit 115. In response to receiving a request to fire signal 191, the control circuit 114 starts the deployment of the pyrotechnic device (as described with respect to Figure 1 or 2) and resets the timer circuit 115 by sending a reset signal 187. The control circuit 114 is further configured to repeatedly compare, during a deployment operation, the ongoing time 188 with a time threshold T_{TIMEOUT} indicating a maximum time that a deployment operation can take. In response to determining that the time 188 exceeds the time threshold T_{TIMEOUT}, the control circuit 114 interrupts the deployment of the pyrotechnic device. Accordingly, the control circuit 114 is configured to, in response to a request to the fire signal 191, drive the pyrotechnic device 101 for a given maximum time.

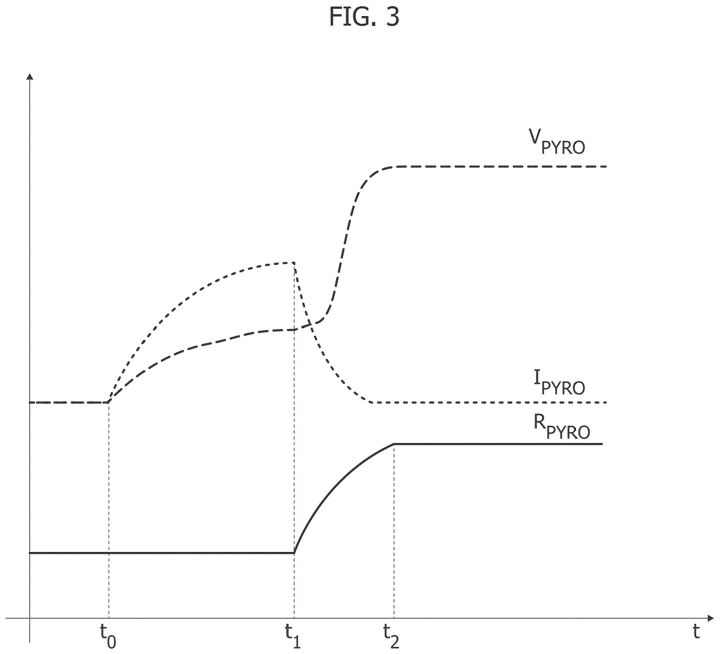

In this respect Figure 3 shows the evolution in time of a current I_{PYRO}, a voltage V_{PYRO} and a resistance R_{PYRO} of a pyrotechnic device 101 during a deployment cycle Starting at an instant t₀ and ending at an instant t₂, i.e., the time between the instants t₀ and t₂ may correspond to the time t_{TIMEOUT}.

As described before, during a deployment cycle, the driving circuit provides via the terminals 122a and 122b a voltage V_{PYRO} and a current I_{PYRO} to the pyrotechnic device 101. Specifically, due to parasitic inductances and/or capacitances, the voltage and current provided to the pyrotechnic device 101 usually does not increase with a step form, but rather increases gradually as shown in Figure 3. Moreover, in the embodiment shown in Figure 2, the current I_{PYRO} may be limited to a given maximum value.

In this respect, as described in the foregoing, the pyrotechnic device 101 essentially represents a resistive load, whereby the voltage V_{PYRO} and the current I_{PYRO} are related based on the Ohm's law, i.e., V_{PYRO} = I_{PYRO} · R_{PYRO}, where R_{PYRO} corresponds to the resistance of the pyrotechnic device 101.

Specifically, during a deployment cycle, the resistance R_{PYRO} remains initially substantially constant, typical of a non-deployed pyrotechnic device. During this time period the chemical reaction causing the firing of the pyrotechnic device is not triggered yet, indicating that there are no changes in the structure and composition of the pyrotechnic device initiator while the deployment current I_{PYRO} flows through it.

Successively, at a time instant t₁, the pyrotechnic device 101 starts to fire. Specifically, the firing causes a sudden increase of the resistance R_{PYRO}. Accordingly, the deployment circuit 100 of document IT102024000002019 is configured to detect this increase of the resistance R_{PYRO} as a successful deployment of the pyrotechnic device and asserts the fire good signal 190a.

Specifically, document IT102024000002019 discloses that the measurement of the resistance R_{PYRO} may be performed via a dedicated measurement current I_{MEAS} or via the current I_{PYRO} used during the deployment.

For example, when using a measurement current I_{MEAS}, the deployment circuit 100 may be configured to provide via the terminals 122a and 122b the (small) measurement current I_{MEAS} and evaluate the value of the signal 194. In fact, when the pyrotechnic device 101 is in an undeployed condition, the resistance R_{PYRO} should have a first value R_{PYRO1}. Specifically, this first value R_{PYRO1} should be within a given predetermined range. For example, in various known solutions, a similar measurement is used to determine periodically, whether the pyrotechnic device 101 is connected correctly to the terminals 122a and 122b. Specifically, in the absence of a fire request, the deployment circuit 100 may be configured to periodically:
- apply via the driving circuit a measurement current I_{MEAS} to the terminals 122a and 122b;
- monitor via the processing circuit 112 the voltage V_{PYRO} and determine a signal 195 being indicative of the resistance R_{PYRO}; and
- determine via the comparator 112 whether the signal 195 is between a lower and an upper threshold.

For example, in this case, in response to determining that the signal 195 is not within the threshold, the deployment circuit 100 may signal a malfunction of the pyrotechnic device 101.

Accordingly, similarly, once having completed a deployment cycle, the deployment circuit 100 may be configured to perform a new measurement of the resistance R_{PYRO} via the measurement current I_{MEAS}, and determine whether the signal 195 is greater than the threshold 196. Specifically, in this case, the pyrotechnic device 101 has been deployed correctly when the signal 195 is greater than the threshold 196.

However, also the (higher) deployment current I_{PYRO} during a deployment cycle itself may be used to determine an increase of the resistance R_{PYRO}. In fact, as shown in Figure 3, the voltage V_{PYRO} exhibits a significant increase once the pyrotechnic device 101 deploys at the instant t₂. In this respect, document IT102024000002019 discloses various solutions for detecting the deployment by analyzing just the voltage V_{PYRO}, e.g., in order to detect the increase of the voltage V_{PYRO}, or both the voltage V_{PYRO} and the current I_{PYRO}, e.g., in order to detect the increase of the resistance R_{PYRO}.

The inventors have observed that the solutions disclosed in document IT102024000002019 may incorrectly detect the deployment of the pyrotechnic device 101 under given circumstances.

### Object and summary

Considering the foregoing, it is an object of various embodiments to provide improved solutions, which provide a more reliable detection of the deployment of a pyrotechnic device.

According to one or more embodiments that object may be achieved by means of a deployment circuit for a pyrotechnic device having the distinctive elements set forth specifically in the ensuing claims. Embodiments moreover concern a related integrated circuit, vehicle and method.

The scope of protection is defined in the appended claims, which form an integral part of the technical teaching of the description provided herein.

As mentioned before, various embodiments of the present disclosure relate to a deployment circuit for a pyrotechnic device. In various embodiments, the deployment circuit, e.g., integrated in an integrated circuit, comprises a positive terminal and a negative terminal configured to receive a supply voltage and a first terminal and a second terminal configured to be connected to the pyrotechnic device.

In various embodiments, a driver circuit is configured to selectively energize the pyrotechnic device. For this purpose, the driver circuit may comprise at least one electronic switch and at least one current limiter, wherein the at least one electronic switch is configured to selectively connect the first terminal and the second terminal to the positive terminal and the negative terminal in response to determining that a deployment control signal is asserted, and the at least one current limiter is configured to limit the current provided via the first terminal and the second terminal to a maximum value. For example, in various embodiments, the at least one electronic switch comprises an electronic switch connected between the second terminal and the negative terminal, and the at least one current limiter comprises a current limiter connected between the positive terminal and the first terminal.

In various embodiments, a control circuit is configured to control the driver circuit as a function of a fire request signal. Specifically, in various embodiments, in response to determining that the fire request signal is de-asserted, the control circuit obtains a first value indicative of a resistance between the first terminal and the second terminal. Next, the control circuit determines whether the first value is between a first threshold and a second threshold, wherein the second threshold is greater than the first threshold. In response to determining that the first value is not between the first threshold and the second threshold, the control circuit signals an error. In various embodiments, the control circuit is configured to repeat these operations periodically. In various embodiments, the first threshold corresponds to a minimum resistance value of a correctly connected undeployed pyrotechnic device and the second threshold corresponds to a maximum resistance value of a correctly connected undeployed pyrotechnic device.

In various embodiments, in response to determining that the fire request signal is asserted, the control circuit starts a deployment cycle by setting the maximum value to a first maximum value and asserting the deployment control signal. Next, the control circuit stops the deployment cycle after a given time-period by de-asserting the deployment control signal.

Specifically, in various embodiments, the control circuit is configured to monitor during the deployment cycle a value indicative of the time where the current provided via the first terminal and the second terminal is greater than a current threshold. Moreover, once the deployment cycle has been stopped, the control circuit obtains a second value indicative of the resistance between the first terminal and the second terminal.

Specifically, in various embodiments, the control circuit determines whether the monitored value indicates that the time is greater than a time threshold and whether the second value is greater than a third threshold, wherein the third threshold is greater than the second threshold. For example, the third threshold may correspond to a minimum resistance value of a correctly connected deployed pyrotechnic device.

Specifically, in various embodiments, in response to determining that the monitored value indicates that the time is greater than the time threshold and the second value is greater than the third threshold, the control circuit signals a correct deployment of the pyrotechnic device.

Conversely, when the monitored value indicates that the time is not greater than the time threshold or the second value is not greater than the third threshold, the control circuit may implement different operations.

For example, in various embodiments, in response to determining that the monitored value indicates that the time is greater than the time threshold and the second value is not greater than the third threshold, the control circuit starts a new deployment cycle. Alternatively, the control circuit may also determine whether the second value is greater than the first threshold. In this case, in response to determining that the monitored value indicates that the time is greater than the time threshold, the second value is greater than the first threshold and the second value is not greater than the third threshold, the control circuit may start a new deployment cycle. Conversely, in response to determining that the monitored value indicates that the time is greater than the time threshold, and the second value is not greater than the first threshold, the control circuit may signal an error.

Conversely, in various embodiments, in response to determining that the monitored value indicates that the time is not greater than the time threshold and the second value is greater than the third threshold, the control circuit may signal an error and/or start a new deployment cycle.

In various embodiments, the control circuit may measure the resistance by using the electronic switch used to deploy the pyrotechnic device. Conversely, in other embodiments, the deployment circuit comprises a first current limiter connected between the positive terminal and the first terminal, wherein the first current limiter is configured to limit the current flowing through the first current limiter to the maximum value. Moreover, the deployment circuit comprises a second current limiter and an electronic switch, wherein the electronic switch is configured to selectively connect the second current limiter between the second terminal and the negative terminal as a function of a measurement control signal, wherein the second current limiter is configured to limit the current flowing through the second current limiter to a second maximum value, wherein the second maximum value is smaller than the first maximum value. Accordingly, in this case, the control circuit may obtain a value indicative of a resistance between the first terminal and the second terminal by setting the maximum value of the first current limiter to the second maximum value, asserting the measurement control signal, and obtaining a value indicative of the voltage at the first terminal and the second terminal. For example, the value indicative of a resistance between the first terminal and the second terminal may correspond to the value indicative of the voltage at the first terminal and the second terminal, the value indicative of the voltage at the first terminal and the second terminal divided by a predetermined value, or the value indicative of the voltage at the first terminal and the second terminal divided by value indicative of the current provided via the first terminal and the second terminal.

In various embodiments, the deployment circuit comprising a current measurement circuit configured to obtain a value indicative of the current flowing through the electronic switch connected between the second terminal and the negative terminal. For example, in various embodiments, the electronic switch connected between the second terminal and the negative terminal is an n-channel FET. In this case, the current measurement circuit may comprise a further n-channel FET having a gate terminal connected to a gate terminal of the n-channel FET, which receives the deployment control signal and a regulator circuit configured to vary the current flowing through the further n-channel FET until the drain-source voltage of the further n-channel FET corresponds to the drain-source voltage of the further n-channel FET. In fact, in this way, the current measurement circuit may be configured to obtain the value indicative of the current flowing through the electronic switch by monitoring the current flowing through the further n-channel FET.

In various embodiments, the control circuit may monitor the time via a counter. For example, the control circuit may increase a count value when the current provided via the first terminal and the second terminal is greater than the current threshold during the deployment cycle. Accordingly in this case, the control circuit may determine whether the monitored value indicates that the time is greater than the time threshold by determining whether the count value is greater than a count threshold.

### Brief description of the drawings

The embodiments of the present disclosure will now be described with reference to the annexed plates of drawings, which are provided purely to way of non-limiting example and in which:
The features and advantages of the present invention will become apparent from the following detailed description of practical embodiments thereof, shown by way of non-limiting example in the accompanying drawings, in which:
- Figure 1 shows a first example of a deployment circuit for a pyrotechnic device;
- Figure 2 shows a second example of a deployment circuit for a pyrotechnic device;
- Figure 3 shows exemplary waveforms during a deployment cycle of the deployment circuits of Figures 1 and 2;
- Figure 4 shows a deployment circuit according to the present disclosure;
- Figure 5 shows embodiments of a driver circuit, a voltage measurement circuit and a current measurement circuit for the deployment circuit of Figure 4;
- Figure 6 shows an embodiment of the operation of a control circuit of the deployment circuit of Figure 4;
- Figure 7 shows exemplary waveforms during a deployment cycle of the deployment circuit of Figure 5; and
- Figure 8 shows a further embodiment of a current measurement circuit for the deployment circuit of Figure 4.

### Detailed description

In the ensuing description, various specific details are illustrated aimed at enabling an in-depth understanding of the embodiments. The embodiments may be provided without one or more of the specific details, or with other methods, components, materials, etc. In other cases, known structures, materials, or operations are not shown or described in detail so that various aspects of the embodiments will not be obscured.

Reference to "an embodiment" or "one embodiment" in the framework of this description is meant to indicate that a particular configuration, structure, or characteristic described in relation to the embodiment is comprised in at least one embodiment. Hence, phrases such as "in an embodiment", "in one embodiment", or the like that may be present in various points of this description do not necessarily refer to one and the same embodiment. Moreover, particular conformations, structures, or characteristics may be combined in any adequate way in one or more embodiments.

The references used herein are only provided for convenience and hence do not define the sphere of protection or the scope of the embodiments.

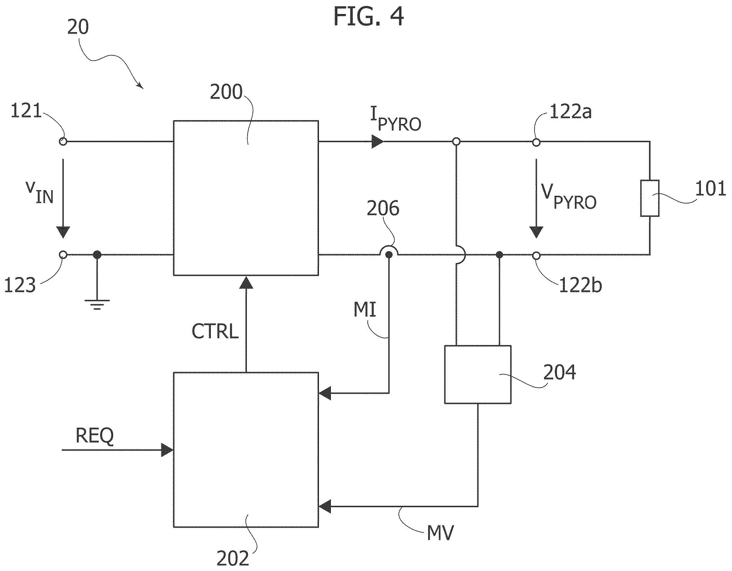

In Figures 4 to 8 described below, parts, elements or components that have already been described with reference to Figures 1 to 3 are designated by the same references used previously in these figures. The description of these elements has already been made and will not be repeated in what follows in order not to burden the present detailed description.

As mentioned before, various embodiments of the present disclosure provide solutions for deploying a pyrotechnic device.

Specifically, the inventors have observed that the solution disclosed in document IT102024000002019 may detect that the pyrotechnic device 101 deployed. However, the deployment circuit may operate incorrectly when the connection to the pyrotechnic device is damaged during the deployment cycle.

For example, in case of an incident, the electric cable connecting the pyrotechnic device 101 to the deployment circuit may be damaged. For example, this may imply that the cables connecting the pyrotechnic device 101 to the deployment circuit are interrupted, thereby generating an open circuit between the terminals 122a and 122b. However, the cables connecting the pyrotechnic device 101 to the deployment circuit may also generate a short-circuit between the terminals 122a and 122b.

For example, in the former case, the circuit of document IT102024000002019 may signal an incorrect deployment because the resistance value R_{PYRO} and similarly the voltage V_{PYRO} increase during the deployment cycle above the threshold value 196. Conversely, also the latter situation is not detected, because the resistance value R_{PYRO} and similarly the voltage V_{PYRO} remain simply below the threshold value 196, whereby the deployment circuit starts a new deployment cycle.

In the following will thus be described solutions for detecting correctly the deployment of the pyrotechnic device 101, such as a squib, a pyro-fuse or a pyro-actuator.

Figure 4 shows an embodiment of a deployment circuit 20 according to the present disclosure. Specifically, the deployment circuit 20 comprises a first terminal 122a and a second terminal 122b configured to be connected to a pyrotechnic device 101. The deployment circuit 20 comprises also a driver circuit 200 configured to provide electric energy to the terminals 122a and 122b. For this purpose, the driver circuit 20 may comprise a first (positive) terminal 121 and a second (negative) terminal 123 configured to receive a supply voltage V_{IN}. For example, the terminal 123 may represent a ground.

For example, as disclosed with respect to Figure 1, in various embodiments, the driver circuit 200 may be configured to connect the terminals 122a and 122b to a supply voltage supply voltage V_{IN}, whereby a current I_{PYRO} is provided via the terminals 122a and 122b. In various embodiments, the driver circuit 20 may also comprise a current limiter configured to limit the current I_{PYRO} to a maximum value.

In the embodiment considered, the deployment circuit 20 comprises also a control circuit 202 configured to control the operation of the driver circuit 200 via one or more control signals CTRL. For example, in order to start a deployment cycle, the control circuit 202 may set the control signals CTRL in order to indicate that energy should be provided to the pyrotechnic device 101. Accordingly, in various embodiments, the control circuit 202 receives also a fire request signal REQ indicating that a deployment of the pyrotechnic device 101 is requested.

As shown in Figure 4, in various embodiments, the deployment circuit 20 comprises also a current sensor 206 configured to generate a signal MI indicative (e.g., proportional to) the current I_{PYRO} provided via the terminals 122a and 122b. In various embodiments, the deployment circuit 20 comprises also a voltage sensor 204 configured to generate a signal MV indicative (e.g., proportional to) the voltage V_{PYRO} at the terminals 122a and 122b.

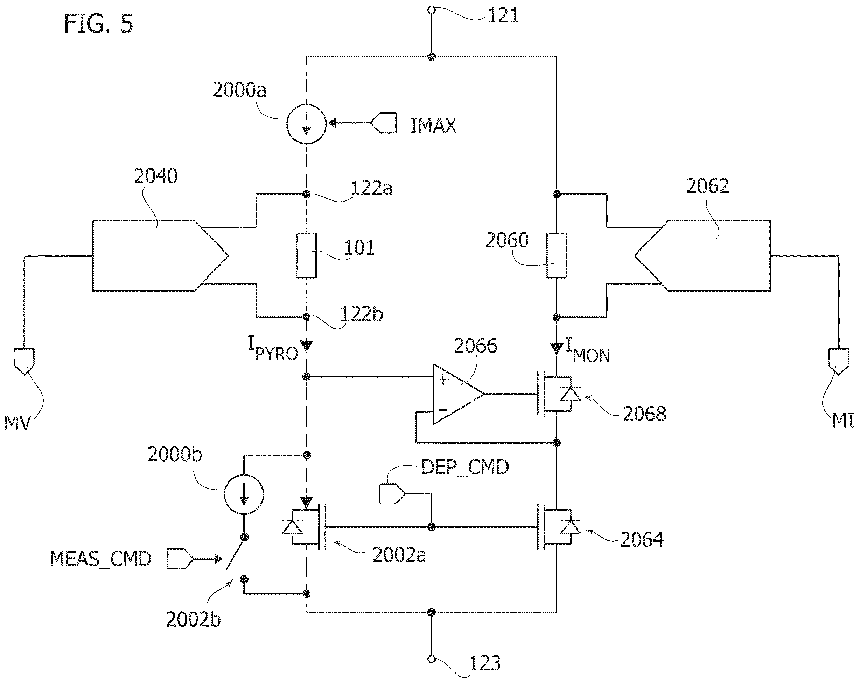

Figure 5 shows an embodiment of the driver circuit 200. Specifically, in the embodiment considered, the driver circuit 200 is configured to selectively enable a current flow through the pyrotechnic device 101.

Specifically, in the embodiment considered, the driver circuit 200 comprises one or more electronic switches configured to selectively connect the terminals 122a and 122b to the voltage V_{IN} (received at the terminals 121 and 123) in response to determining that a signal DEP_CMD is asserted. For example, in the embodiment considered, the driver circuit 200 comprises one or more electronic switches having a current path connected in series with the terminals 122a and 122b between the terminals 121 and 123.

For example, in the embodiment considered, (the current path of) an electronic switch 2002a is connected (e.g., directly) between the terminals 122b and 123, wherein the electronic switch 2002a is closed in response to determining that the signal DEP_CMD is asserted. For example, in the embodiment considered, the electronic switch 2002a is a Field-Effect Transistor, such as an n-channel FET having a drain terminal connected to the terminal 122b, a source terminal connected to the terminal 123 and the gate terminal receives the signal DEP_CMP. Additionally or alternatively, the driver circuit 200 may comprises an electronic switch having a current path connected between the terminals 121 and 122a, wherein the electronic switch is closed when the signal DEP_CMD is asserted.

In various embodiments, the driver circuit 200 comprises also one or more current limiters connected in series with the terminals 122a and 122b. For example, in the embodiment considered, a current limiter 2000a is connected between the terminals 121 and 122a. Additionally or alternatively, a current limiter may be connected between the terminals 122b and 123.

In various embodiments, the maximum value of the one or more current limiters, e.g., the current limiter 2000a, may be settable via a signal IMAX. For example, a current limiter may be implemented with an output branch of a current mirror, wherein the current in an input branch of the current mirror is settable, e.g., via a current digital-to-analog converter (IDAC), or via a plurality of current limiters which are selectively enabled.

Accordingly, in the embodiment considered, the control circuit 202 may assert the signal DEP_CMD to request that a current is provided via the terminals 122a and 122b, wherein the maximum value of the current I_{PYRO} may be settable via the signal IMAX.

Specifically, in various embodiments, the current limiter 2000a is configured to use (at least) two maximum values I_{DEP} and I_{MEAS}. For example, in this case, the signal IMAX may be a binary signal selecting one of the two maximum values. Specifically, in various embodiments, the maximum values I_{DEP} is used when the pyrotechnic device 101 should be deployed, while the maximum values I_{MEAS} is used to measure the resistance between the terminals 122a and 122b. Accordingly, in various embodiments, the current flow may be generated by setting via the signal IMAX the maximum value of the current I_{PYRO} to the value I_{DEP} or I_{MEAS}, and asserting the signal DEP_CMD.

Figure 5 also shows an alternative embodiment, wherein the driver circuit 200 comprises an additional current limiter 2000b and an additional electronic switch 2002b, which are connected in series between the terminals 122b and 123. Specifically, in the embodiment considered, the current limiter 2000b uses a maximum value of I_{MEAS} and the electronic switch 2002b is closed in response to determining that a signal MEAS_CMD is asserted.

Accordingly, in the embodiment considered, the signal DEP_CMD may be used to request the execution of a deployment cycle. Specifically, in response to the signal DEP_CMD, the current limiter 2000a may use the maximum values I_{DEP} and the electronic switch 2002a may be closed. For example, for this purpose, the signal DEP_CMD may enable a first current limiter within the current limiter 2002a, wherein the first current limiter uses the maximum value I_{DEP}.

Conversely, the signal MEAS_CMD may be used to request a measurement cycle. Specifically, in response to the signal MEAS_CMD, the current limiter 2000a may use the maximum values I_{MEAS} and the electronic switch 2002b may be closed. For example, for this purpose, the signal MEAS_CMD may enable a second current limiter within the current limiter 2002a, wherein the second current limiter uses the maximum value I_{MEAS}. Accordingly, in the embodiment considered, the current I_{PYRO} is limited both in the upper branch (between the terminals 121 and 122a) and the lower branch (between the terminals 122b and 123) to the maximum value I_{MEAS}. Specifically, the additional current limiter 2000b and the additional electronic switch 20002b have the advantage that various types of connection errors may be detected by monitoring the voltages at the terminals 122a and 122b.

Figure 5 shows also an embodiment of the voltage measurement circuit 204, however also other solutions may be used to measure the voltage V_{PYRO} at the terminals 122a and 122b. For example, in Figure 5, the measurement circuit 204 comprises an (e.g., differential) analog-to-digital converter 2040 configured to generate a digital sample MV by sampling the voltage at the terminals 122a and 122b. However, the analog-to-digital converter 2040 may also sample the voltage at the terminal 122a and the voltage at the terminal 122b and calculate a difference. Thus, also other analog-to-digital conversion circuits may be used to generate samples MV of the voltage V_{PYRO} at the terminals 122a and 122b.

Figure 5 shows also an embodiment of the current measurement circuit 206, however also other solutions may be used to measure the current I_{PYRO} provided via the terminals 122a and 122b. Specifically, when using a current limiter 2000a connected between the terminals 121 and 122a, it is preferable that the current sensor 206 measures the current flowing between the terminals 122b and 123. For example, this permits to determine whether one of the terminals 122a and 122b is short-circuited to ground. Additionally or alternatively, a current sensor 206 may be configured to measure the current flowing between the terminals 121 and 122a.

For example, in various embodiments, the current sensor 206 is configured to apply a current being proportional to the current flowing through the electronic switch 2002a to a resistance 2060, such as a resistor. Accordingly, in the embodiment considered, the voltage at the resistance 2060 is proportional to the current flowing though the electronic switch 2002a. Accordingly, in the embodiment considered, the current sensor 206 may comprise an (e.g., differential) analog-to-digital converter 2062 configured to generate a digital sample MI by sampling the voltage at the resistance 2060. However, the analog-to-digital converter 2062 may also sample the voltages at the terminals of the resistance 2060 and calculate a difference. Thus, also other analog-to-digital conversion circuits may be used to generate samples MI of the voltage at the resistance 2060.

In the simplest case, the resistance 2060 may be connected in series with the electronic switch 2002a. However, this may also influence the current flow through the pyrotechnic device 101. Accordingly, in various embodiments, the current sensor 206 comprise a further n-channel FET 2064 and a regulator circuit configured to vary the current flowing through the FET 2064 until the voltage between the drain and source terminals of the FET 2064 corresponds to the voltage between the drain and source terminals of the FET 2002a. In fact, in this case, based on the scaling N between the FETs 2002a and 2064, the current flowing I_{MON} through the FET 2064 is proportional to the current I_{PYRO} flowing through the FET 2002a. For example, in various embodiments, the transistor 2002a has a scaling of N = 1000 with respect to the transistor 2064, i.e. I_{MON} = I_{PYRO}/1000.

For example, in the embodiment considered, the regulator circuit is implemented with a FET 2068, substantially acting as a variable/adjustable current source, and an operational amplifier 2066 having a first input terminal connected to the drain terminal of the FET 2002a and a second input terminal connected to the drain terminal of the FET 2064, wherein the output of the operational amplifier 2066 drives the gate of the FET 2068. For example, when the FET 2068 is an n-channel FET, the first input terminal of the operational amplifier 2066 may correspond to the positive/non-inverting input terminal and the second input terminal of the operational amplifier 2066 may correspond to the negative/ inverting input terminal. Conversely, with a p-channel FET 2068, the connection is inverted.

Accordingly, in the embodiment considered, the FET 2068 is suitably biased and the resistance 2060 is connected in series with (the current paths of) the FETs 2068 and 2064. For example, in the embodiment considered, the drain terminal of the n-channel FET 2068 is connected via the resistance 2060 to a bias voltage, e.g., the drain terminal of the n-channel FET 2068 is connected via the resistance 2060 to the terminal 121. Conversely, the source terminal of the n-channel FET 2068 is connected to the drain terminal of the FET 2064.

In various embodiments, the resistance 2060 and the voltage ADC 2062 may also be replaced with a current analog-to-digital converter. For example, the drain terminal of the n-channel FET 2068 may be connected to the input of the current analog-to-digital converter, whereby the current analog-to-digital converter provides the signal MI by sampling the current I_{MON}.

In various embodiments, the voltage analog-to-digital converters 2040 and 2062 may also be implemented with the same analog-to-digital converter, e.g., having an input multiplexer. Additionally or alternatively, the analog-to-digital converters 2040 and 2062 may be integrated in the control circuit 202. For example, in this case, the control circuit 202 may be implemented with a micro-controller comprises one or more analog-to-digital converters. In this case, the current digital-to-analog converter possibly be used to set the maximum value I_{MAX} may be implemented with a current digital-to-analog converter of the microcontroller. Similarly, a current digital-to-analog converter possibly be used to sample the current I_{MON} may be implemented with a current digital-to-analog converter of the microcontroller. In various embodiments, the operations of the control circuit 202 may also be implemented via analog processing circuits, i.e., the digital-to-analog converters and digital-to-analog converters is purely optional.

Those of skill in the art will appreciate that, when using also the optional current limiter 2000b and the optional electronic switch 2002b, the current measurement circuit 206 shown in Figure 5 monitors the current I_{PYRO} only during a deployment cycle when the signal DEP_CMD is asserted. However, if required also different or plural current measurement circuits 206 may be used to monitor the current I_{PYRO} both during a deployment cycle and a measurement cycle.

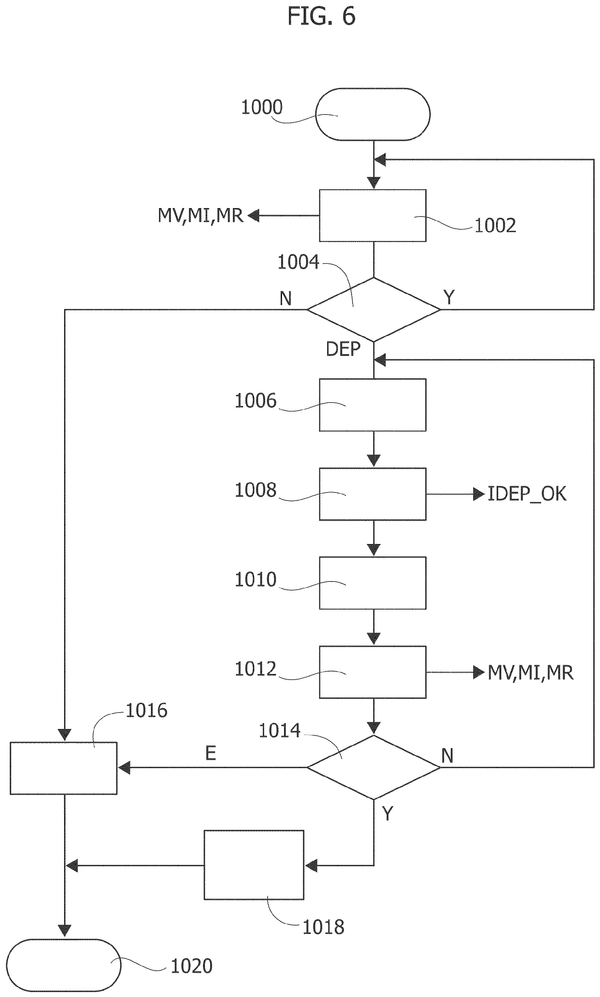

Figure 6 shows an embodiment of the operation of a control circuit 202 according to the present disclosure. The operation shown in Figure 6 may be implemented in any suitable manner, including hardware implementations, software implementations or a combination thereof. For example, in various embodiment, the control circuit 202 is implemented with a microcontroller comprising a microprocessor. In this case, the operations may be implemented via software instructions, which cause the microprocessor to implement the operations when the software instructions are executed by the microprocessor. Alternatively, the operation may be implemented via a Finite-State Machine (FSM) implemented with a hardware sequential logic circuit. Alternatively, the operations may also be implemented at least in part via analog circuits. Thus, in general, any suitable analog and/or digital circuit may be used to implement the operation of the control circuit 202.

Specifically, after a start step 1000, the control circuit 202 proceeds to a step 1002, where the control circuit 202 determines a value MR being indicative for the resistance R_{PYRO} between the terminals 122a and 122b.

For example, when omitting the current limiter 2000b and the electronic switch 2002b of Figure 5, the control circuit 202 may start a measurement cycle by setting via the signal IMAX a maximum current I_{MEAS} for the current limiter (e.g., the current limiter 2000), wherein the value I_{MEAS} corresponds preferably to a small measurement current, and asserting the signal DEP_CMD. Conversely, when using the current limiter 2000b and the electronic switch 2002b, the control circuit 202 may assert the signal MEAS_CMD and set via the signal IMAX (or directly the signal MEAS_CMD) a maximum current I_{MEAS} for the current limiter 2000a.

For example, in various embodiments, the current I_{MEAS} is selected in a range between 5 and 100 mA, e.g., between 20 and 60 mA, e.g., about 40 mA. In various embodiments, the value I_{MEAS} may be settable, e.g., programmable. For example, programmable values disclosed herein may be received via a communication interface of the control circuit 202 and/or stored to a non-volatile memory of the control circuit 202.

Next, in various embodiments, the control circuit 202 obtains the signals MV and MI and computes the value MR (indicative of the resistance R_{PYRO}) as the ratio MV/MI, i.e., MR = MV/MI. In various embodiments, instead of explicitly measuring the current I_{PYRO}, which should correspond to the maximum value I_{MEAS}, the control circuit 202 may assume that the value MI corresponds to a predetermined value (corresponding to the value I_{MEAS}), i.e. the control circuit 202 may compute the value MR (indicative of the resistance R_{PYRO}) as the ratio MV/MI, i.e., MR = MV/MI, where MI is a predetermined value. In various embodiments, the control circuit 202 may assume that the value MI corresponds to a predetermined value (corresponding to the value I_{MEAS}), and simply use the value MV for the value MR, i.e., MR = MV.

Finally, in the embodiment considered, the control circuit 202 stops the measurement cycle, e.g., by de-asserting the signal DEP_CMD or MEAS_CMD.

Specifically, in case an undeployed pyrotechnic device 101 is connected between the terminals 122a and 122b, the resistance R_{PYRO} between the terminals 122a and 122b should be in an expected range. Accordingly, in various embodiments, the control circuit 202 compares at a step 1004 the value MR (indicative of the resistance R_{PYRO}) with a first and a second threshold, where the second threshold is greater than the first threshold. For example, a typical undeployed pyrotechnic device 101 should have a resistance value between 1 and 3 Ω. However, also the connection cables used to connect the pyrotechnic device 101 may have additional resistances, e.g., in a range between 0.1 and 1.1 Ω. Accordingly, in various embodiments, the first threshold may indicate a minimum resistance of a correctly connected undeployed pyrotechnic device 101, e.g., a resistance of 1 Ω, and the second threshold may indicate a maximum resistance of a correctly connected undeployed pyrotechnic device 101, e.g., a resistance of 3 Ω. In various embodiments, the first threshold and/or the second threshold may be settable, e.g., programmable.

Accordingly, in various embodiments, in response to determining that the value MR is smaller than the first threshold or greater than the second threshold (output "N" of the verification step 1004), the control circuit 202 proceeds to a step 1016 where an error is signaled and the operation terminates at a stop step 1020. For example, in various embodiments, the control circuit 202 sets a status signal to indicate an error of the pyrotechnic device 101.

In various embodiments, the control circuit 202 may also signal various types of errors. For example, in response to determining that the value MR is smaller than the first threshold, the control circuit 202 may signal a first error type, e.g., indicative of a short-circuit error. Conversely, in response to determining that the value MR is greater than the second threshold, the control circuit 202 may signal a second error type, e.g., indicative of an open-circuit error.

In various embodiments, the control circuit 202 may also determine at the step 1014 whether the value MI (indicative of the current I_{PYRO}) has an expected value (corresponding to the value I_{MEAS}). For example, in this case, the control circuit 202 may proceed to the error step 1016 also in response to determining that the signal MI has not the expected value. In various embodiments, the control circuit 202 may be configured to determine the expected value a function of the value I_{MEAS}, e.g., the current value of the value IMAX. Alternatively, the expected value may be settable, e.g., programmable.

Additionally or alternatively, in various embodiments, the control circuit 202 may also monitor at the step 1002 via a first current sensor a first current flowing between the terminals 121 and 122a, and via a second current sensor a second current flowing between the terminals 122b and 123. In this case, the control circuit 202 may also determine at the step 1004 whether the first current corresponds (approximately) to the second current. For example, in this case, the control circuit 202 may proceed to the error step 1016 also in response to determining that the first current does not correspond (approximately) to the second current, which e.g., indicates a leakage condition.

Additionally or alternatively, in various embodiments, the control circuit 202 may compare the voltage at the terminal 122a and/or the voltage at the terminal 122b within respective expected value ranges. For example, in this way the control circuit 202 may detect that the terminal 122a and/or the terminal 122b is connected to the supply voltage V_{IN} or ground.

Thus, in various embodiments, the steps 1002 and 1004 are used to determine whether an undeployed pyrotechnic device 101 is correctly connected to the terminals 122a and 122b.

In various embodiments, the control circuit 202 is configured to periodically repeat the steps 1002 and 1004. For example, in Figure 6, in response to determining that the value MR is greater than the first threshold and smaller than the second threshold (output "Y" of the verification step 1004), the control circuit 202 returns to the step 1002. When using also the additional verification operations for the current I_{PYRO}, the control circuit 202 may return to the step 1002 only in case also the value MI has the expected value and/or the first current corresponds (approximately) to the second current.

Figure 6 shows a further output of the verification step 1004. Specifically, in various embodiments, the control circuit 202 verifies at the step whether the signal fire request signal REQ is asserted. However, this verification may be implemented via an additional verification step, or may be implemented asynchronously with respect to the periodic verification at the steps 1002 and 1004, e.g., via an interrupt of a microprocessor of the control circuit 202 or via separate hardware circuit. In various embodiments, the periodic verification at the steps 1002 and 1004 is repeated as long as the fire request signal REQ remains de-asserted.

Specifically, in response to determining that the fire request signal REQ is asserted (e.g., output "DEP" of the verification step 1004), the control circuit 202 proceeds to a step 1006. Specifically, at the step 1006, the control circuit 202 starts a deployment cycle. For example, in various embodiments, the control circuit 202 starts a deployment cycle by setting via the signal IMAX (or directly the signal DEP_CMD) a maximum current I_{DEP} for the current limiter (e.g., the current limiter 2000a), wherein the value I_{DEP} corresponds preferably to a maximum deployment current, and asserting the signal DEP_CMD. For example, in various embodiments, the maximum current I_{DEP} is selected in a range between 1 and 4 A, e.g., between 1 and 3.5 A, e.g., about 1.2 A, 1.5 A, 1.75 A, 2.0 A or 3.5 A.

Next, the control circuit 202 monitors at a step 1008 the value MI for a given time period t_{DC} and, once the time period t_{DC} has elapsed, the control circuit 202 stops the deployment cycle at a step 1010, e.g., by de-asserting the signal DEP_CMD.

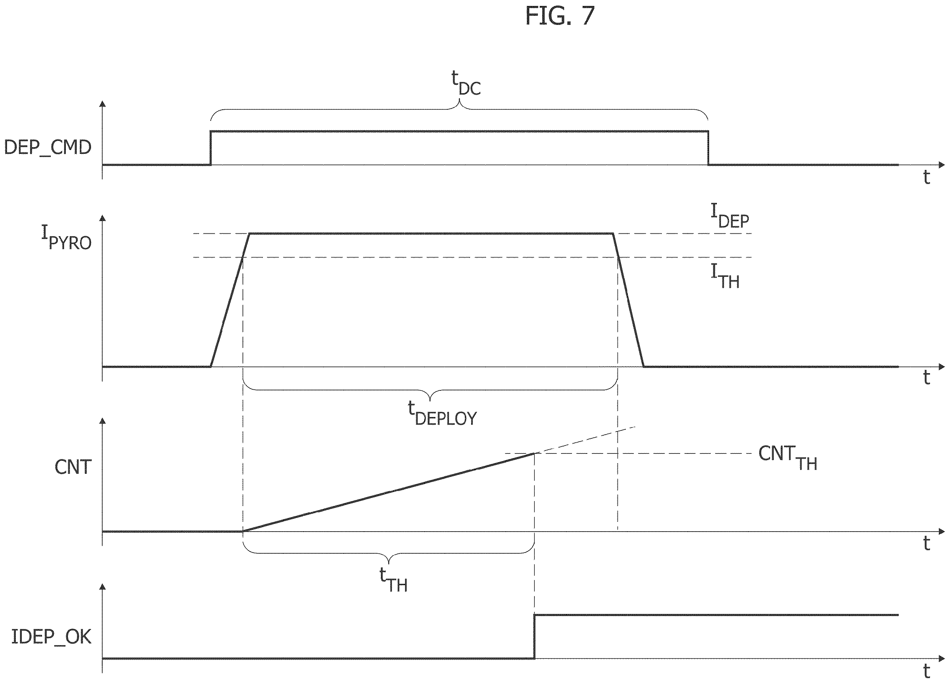

Specifically, as shown in Figure 7, once the signal DEP_CMD is asserted, the current I_{PYRO} provided to the pyrotechnic device 101 should increase to the maximum value I_{DEP}. Moreover, once the pyrotechnic device 101 deploys after a time t_{DEPLOY}, the current I_{PYRO} decreases again, because the resistance R_{PYRO} increases.

For this reason, in various embodiments, the control circuit 202 determines whether a time period t_{DEPLOY} where the current I_{PYRO} is greater than a given threshold I_{TH} is longer than a time threshold t_{TH}. In various embodiments, in order to determine whether the current I_{DEP} is provided to the pyrotechnic device 101, the threshold I_{TH} may be selected in a range between 70% and 95% of the current I_{DEP}.

Accordingly, in various embodiments, the control circuit 202 periodically compares the signal MI with a respective threshold MI_{TH} (indicative of the threshold I_{TH}). In response to determining that the signal MI is greater than the threshold MI_{TH}, the control circuit 202 increases a count value CNT. Conversely, in response to determining that the signal MI is smaller than the threshold MI_{TH}, the control circuit 202 inhibits the increasing of the count value CNT. Accordingly, in the embodiment considered, the value MI_{TH} may be selected in a range between 70% and 95% of the value of the signal MI when the current I_{PYRO} corresponds to the maximum value I_{DEP}. In various embodiments, the control circuit 202 is configured to determine the threshold MI_{TH} a function of the value I_{DEP}, e.g., the current value of the value IMAX. Alternatively, the threshold MI_{TH} may be settable, e.g., programmable.

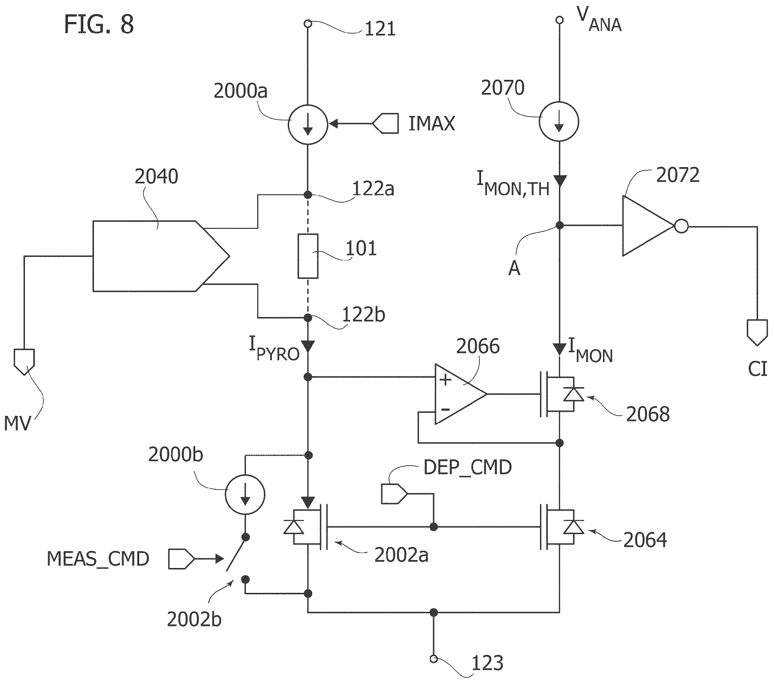

Figure 8 shows an alternative embodiment, wherein the comparison is implemented directly in the current measurement circuit 206. Specifically, in the embodiment considered, the transistors 2064 and 2068 are connected between a node A and the terminal 123. Moreover, a current source 2070 is connected between a supply voltage, e.g., the voltage V_{IN} or an additional supply voltage V_{ANA}, and the node A.

Specifically, in the embodiment shown in Figure 5, the current I_{MON} is proportional to the current I_{PYRO}, i.e., I_{MON} = I_{PYRO}/N, where N corresponds to the scaling between the transistors 2002a and 2064, e.g., N = 1000. Conversely, in the embodiment shown in Figure 8, the current source 2070 is configured to provide a maximum current of I_{MON,TH} = M · (I_{PYRO}/N), where M represents the percentage of the threshold for the current I_{DEP}, e.g., M is selected in a range between 0.7 and 0.95.

Accordingly, in the embodiment considered, when the transistor 2068 sinks a current being smaller than I_{MON,TH}, i.e., because the current I_{PYRO} is smaller than the threshold I_{TH}, the voltage at the node A is high. Conversely, when the transistor 2068 sinks a current being greater than I_{MON,TH}, i.e., because the current I_{PYRO} is greater than the threshold I_{TH}, the voltage at the node A is low. Accordingly, in this way, the voltage at the node A indicates directly the fact that the current I_{PYRO} is greater or smaller than the threshold I_{TH}. For example, in various embodiments, the current measurement circuit 206 comprise a logic inverter 2072 configured to generate a signal CI as a function of the voltage at the node A. Accordingly, in this case, in response to determining that the signal CI is asserted, the control circuit 202 may increase the count value CNT. Conversely, in response to determining that the signal CI is de-asserted, the control circuit 202 may inhibit the increasing of the count value CNT. In various embodiments, the current comparison operation may also be implemented with other types of analog comparison circuits.

Accordingly, the count value CNT is indicative of the time in which the current I_{PYRO} is greater than the current I_{TH}. Accordingly, the control circuit 202 may be configured to assert a signal IDEP_OK once the count value CNT exceeds a count threshold CNT_{TH}, which corresponds to the requested minimum time t_{TH}. In various embodiments, the verification of the count value CNT may be performed during the deployment cycle, e.g., during the step 1008, or after the deployment cycle, e.g., at the step 1010. In various embodiments, the time threshold t_{TH} or the count threshold CNT_{TH} may be settable, e.g., programmable.

In various embodiments, the count value CNT may be provided by a digital counter or an analog ramp generated. Accordingly, also the comparison of the count value may be implemented via a digital or analog comparator, respectively.

Once the control circuit 202 has stopped the deployment cycle at the step 1010, the control circuit 202 proceeds to a step 1012, where the control circuit 202 obtains again a value MR being indicative for the resistance R_{PYRO} between the terminals 122a and 122b. For a description of this step, reference may be made to the step 1002. For example, as described in the foregoing, the control circuit 202 may start a measurement cycle by setting via the signal IMAX the maximum current I_{MEAS} for the current limiter (e.g., the current limiter 2000), and asserting the signal MEAS_CMD (or alternatively the signal DEP_CMD). Next, the control circuit 202 obtains the value MV and optionally MI, and determines the respective value MR, e.g., MR = MV/MI or MR = MV, where MV corresponds to a measured value, and MI corresponds to measured or predetermined value.

Finally, the control circuit 202 stops the measurement cycle by de-asserting the signal MEAS_CMD (or alternatively the signal DEP_CMD). In various embodiments, the computation of the value MR at the steps 1002 and 1012 may also be performed, once the measurement cycle has ended.

Specifically, in case a deployed pyrotechnic device 101 is correctly connected between the terminals 122a and 122b, the resistance R_{PYRO} between the terminals 122a and 122b should be in an expected range. For example, a correctly connected deployed pyrotechnic device 101 may have a resistance R_{PYRO} of at least 100 Ω.

Accordingly, in various embodiments, the control circuit 202 compares the value MR with a third threshold indicative of a minimum resistance of a correctly connected deployed pyrotechnic device 101, e.g., a resistance of 100 Ω. In various embodiments, the third threshold may be settable, e.g., programmable.

Accordingly, in various embodiments, the control circuit may verify at a step 1014 whether:
- the deployment current I_{DEP} has been provided for a minimum time t_{TH} to the terminals 122a and 122b, e.g., because the signal IDEP_OK is asserted, and
- at the end of the deployment cycle (of time t_{DC}), the resistance R_{PYRO} has increased above the third threshold indicative of a deployed pyrotechnic device.

Specifically, in response to determining that the deployment current I_{DEP} has been provided for the minimum time t_{TH} and the resistance R_{PYRO} has increased above the third threshold (output "Y" of the verification step 1014), the control circuit 202 may assume that the pyrotechnic device 101 has deployed and the operation terminates at the stop step 1020. In various embodiments, prior to proceeding to the stop step, the control circuit 202 may signal a correct deployment of the pyrotechnic device 101. For example, in various embodiments, the control circuit 202 sets the status signal to indicate a correct deployment of the pyrotechnic device.

Conversely, in case at least one of the verifications is not successful, i.e., in response to determining that the deployment current I_{DEP} has not been provided for the minimum time t_{TH} or the resistance R_{PYRO} has not increased above the third threshold, the control circuit 202 may perform different operations. For example, in the simplest case (output "N" of the verification step 1014), the control circuit 202 may return to the step 1006 for starting a new deployment cycle, eventually resetting also the count value CNT.

However, when the connection to the pyrotechnic device 101 is interrupted during the deployment cycle, thereby generating an open-circuit between the terminals 122a and 122b, the current I_{PYRO} decreases and the resistance R_{PYRO} increases, which represents an error. Accordingly, in various embodiments, in response to determining that the deployment current I_{DEP} has not been provided for the minimum time t_{TH} and the resistance R_{PYRO} has increased above the third threshold, the control circuit 202 may proceed to the error step 1016. For example, in this case, the control circuit 202 may generate an error signal, which may be used to activate another deployment circuit for the same pyrotechnic device 101 or another pyrotechnic device. Additionally or alternatively, in various embodiments, the control circuit 202 sets the status signal to indicate an error during the deployment of the pyrotechnic device. For example, in this case, the control circuit 202 may set the status signal to indicate an open-circuit condition during the deployment of the pyrotechnic device.

Accordingly, in various embodiments, the control circuit 202 may (only) return to the step 1006 in response to determining that the deployment current I_{DEP} has been provided for the minimum time t_{TH} and the resistance R_{PYRO} has not increased above the third threshold.

In various embodiments, similar to the step 1004, the control circuit 202 may implement further verification operations. For example, in various embodiments, the control circuit 202 verifies whether the value MR is greater than the first threshold indicative for the minimum value of an undeployed pyrotechnic device 101. For example, in this case, the control circuit 202 may proceed to the error step 1016 in response to determining that the value MR is smaller than the first threshold, which likely indicates a short circuit between the terminals 122a and 122b. For example, in this case, the control circuit 202 may set the status signal to indicate a short-circuit condition during the deployment of the pyrotechnic device.

Additionally or alternatively, in various embodiments, the control circuit 202 may also monitor at the step 1012 via a first current sensor a first current flowing between the terminals 121 and 122a, and via a second current sensor a second current flowing between the terminals 122b and 123. In this case, the control circuit 202 may also determine at the step 1014 whether the first current corresponds (approximately) to the second current. For example, in this case, the control circuit 202 may proceed to the error step 1016 also in response to determining that the first current does not correspond (approximately) to the second current, thereby detecting possible leakage currents to the terminals 121 and 123. For example, in this case, the control circuit 202 may set the status signal to indicate leakage error during the deployment of the pyrotechnic device.

Additionally or alternatively, in various embodiments, the control circuit 202 may compare the voltage at the terminal 122a and/or the voltage at the terminal 122b with respective expected value ranges. For example, in this way the control circuit 202 may detect that the terminal 122a and/or the terminal 122b is connected to the supply voltage V_{IN} or ground. For example, in this case, the control circuit 202 may proceed to the error step 1016 also in response to determining that the voltage at the terminal 122a and/or the voltage at the terminal 122b are not within respective expected value ranges.

Accordingly, in various embodiments, the value MR obtained at the step 1002 should be between the first and second threshold (e.g., between 1 and 3 Ω), while the value MR obtained at the step 1012 should be greater than the third threshold (e.g., greater than 100 Ω). In various embodiments, when using an ADC 2040, the control circuit 202 may thus be configured to change the respective input range of the ADC. Similarly, when using the ADC 2062 (or a similar current ADC), the control circuit 202 may change the respective input range of the ADC, because the deployment current I_{DEP} should be significantly greater than the measurement current I_{MEAS}.

Accordingly, the control circuit 202 disclosed herein is able to reliably detect the correct deployment of the pyrotechnic device by monitoring the time t_{DEPLOY} (step 1008) and the resistance R_{PYRO} after the deployment cycle (1010). Specifically, in various embodiments, the control circuit 202 detects at the step 1014 a correct deployment when the time t_{DEPLOY} is greater than the time threshold t_{TH} and the resistance R_{PYRO} is greater than the minimum resistance of a deployed pyrotechnic device.

Moreover, the control circuit 202 may implement an auto-retry mechanism, when the step 1014 signals that the pyrotechnic device 101 has likely not deployed during the deployment cycle (step 1008). In various embodiments, the control circuit 202 may also be configured to monitor the number of retries. As described in the foregoing, the control circuit 200 may also implement additional controls in order to detect errors during the deployment cycle.

The deployment circuit 20 described in the foregoing may be used for various types of pyrotechnic devices, e.g., within a pyro-fuse or squib. In fact, one or more of the parameters of the control circuit 202 (e.g., the first, second and third threshold for the value MR, the values IMAX for the measurement current I_{MEAS} and the deployment current I_{DEP}, the current threshold I_{TH} or MI_{TH}, and/or the time threshold t_{TH} or the count threshold CNT_{TH}) may be settable, e.g., programmable, for the specific pyrotechnic device 101.

Moreover, in high-end systems, the control circuit 202 may assert a signal once a given maximum number of retries has been performed (or an error condition has been detected at the verification step 1014). For example, this signal may be used to drive a redundant driver circuit, in Figure 5, or a redundant deployment circuit 20.

Of course, without prejudice to the principle of the invention, the details of construction and the embodiments may vary widely with respect to what has been described and illustrated herein purely by way of example, without thereby departing from the scope of the present invention, as defined by the ensuing claims.

## Claims

1. A deployment circuit (20) for a pyrotechnic device (101), comprising:
- a positive terminal (121) and a negative terminal (123) configured to receive a supply voltage (V_{IN});
- a first terminal (122a) and a second terminal (122b) configured to be connected to said pyrotechnic device (101);
- a driver circuit (200) configured to energize said pyrotechnic device (101), wherein said driver circuit (200) comprises at least one electronic switch (2002a) and at least one current limiter (2000a), wherein said at least one electronic switch (2002a) is configured to selectively connect said first terminal (122a) and said second terminal (122b) to said positive terminal (121) and said negative terminal (123) in response to determining that a deployment control signal (DEP_CMD) is asserted, and wherein said at least one current limiter (2000a) is configured to limit the current (I_{PYRO}) provided via said first terminal (122a) and said second terminal (122b) to a maximum value (IMAX);
- a control circuit (202) configured to drive said driver circuit (200) as a function of a fire request signal (REQ);
wherein said control circuit (202) is configured to:
- in response to determining that said fire request signal (REQ) is de-asserted:
- obtain (1002) a first value (MR) indicative of a resistance (R_{PYRO}) between said first terminal (122a) and said second terminal (122b);
- determine (1004) whether said first value (MR) is between a first threshold and a second threshold, said second threshold being greater than said first threshold, and
- in response to determining that said first value (MR) is not between said first threshold and said second threshold, signal (1016) an error;
- in response to determining that said fire request signal (REQ) is asserted:
- start (1006) a deployment cycle by setting said maximum value (IMAX) to a first maximum value (I_{DEP}) and asserting said deployment control signal (DEP_CMD),
- stop (1010) said deployment cycle after a given time period (t_{DC}) by de-asserting said deployment control signal (DEP_CMD),
- monitor (1008) during said deployment cycle a value (CNT) indicative of the time (t_{DEPLOY}) where the current (I_{PYRO}) provided via said first terminal (122a) and said second terminal (122b) is greater than a current threshold (I_{TH}),
- once said deployment cycle has been stopped, obtain (1012) a second value (MR) indicative of the resistance (R_{PYRO}) between said first terminal (122a) and said second terminal (122b),
- determine (1014) whether said monitored value (CNT) indicates that said time (t_{DEPLOY}) is greater than a time threshold (t_{TH}) and whether said second value (MR) is greater than a third threshold, said third threshold being greater than said second threshold, and
- in response to determining that said monitored value (CNT) indicates that said time (t_{DEPLOY}) is greater than said time threshold (t_{TH}) and said second value (MR) is greater than said third threshold, signal (1020) a correct deployment of said pyrotechnic device (101).

2. The deployment circuit according to Claim 1, wherein said control circuit (202) is configured to:
- in response to determining that said monitored value (CNT) indicates that said time (t_{DEPLOY}) is greater than said time threshold (t_{TH}) and said second value (MR) is not greater than said third threshold, start a new deployment cycle.

3. The deployment circuit according to Claim 1, wherein said control circuit (202) is configured to:
- determine whether said second value (MR) is greater than said first threshold,
- in response to determining that said monitored value (CNT) indicates that said time (t_{DEPLOY}) is greater than said time threshold (t_{TH}), said second value (MR) is greater than said first threshold and said second value (MR) is not greater than said third threshold, start a new deployment cycle, and
- in response to determining that said monitored value (CNT) indicates that said time (t_{DEPLOY}) is greater than said time threshold (t_{TH}), said second value (MR) is not greater than said first threshold, signal (1016) an error.

4. The deployment circuit according to Claim 1, wherein said control circuit is configured to:
- in response to determining that said monitored value (CNT) indicates that said time (t_{DEPLOY}) is not greater than said time threshold (t_{TH}) and said second value (MR) is greater than said third threshold, signal (1016) an error and/or start a new deployment cycle.

5. The deployment circuit according to any of the previous claims, comprising:
- a first current limiter (2000a) connected between said positive terminal (121) and said first terminal (122a), wherein said first current limiter (2000a) is configured to limit the current (I_{PYRO}) flowing through said first current limiter (2000a) to said maximum value (IMAX);
- a second current limiter (2000b) and an electronic switch (2002b), wherein said electronic switch (2002b) is configured to selectively connect said second current limiter (2000b) between said second terminal (122a) and said negative terminal (123) as a function of a measurement control signal (MEAS_CMD), wherein said second current limiter (2000b) is configured to limit the current (I_{PYRO}) flowing through said second current limiter (2000b) to a second maximum value (I_{MEAS}), said second maximum value (I_{MEAS}) being smaller than said first maximum value (I_{DEP}),
wherein obtaining (1002, 1012) a value (MR) indicative of a resistance (R_{PYRO}) between said first terminal (122a) and said second terminal (122b) comprises:
- setting said maximum value (IMAX) to said second maximum value (I_{MEAS}),
- asserting said measurement control signal (MEAS_CMD), and
- obtaining (2040) a value (MV) indicative of the voltage (V_{PYRO}) at said first terminal (122a) and said second terminal (122b);
wherein said value (MR) indicative of a resistance (R_{PYRO}) between said first terminal (122a) and said second terminal (122b):
- corresponds to said value (MV) indicative of the voltage (V_{PYRO}) at said first terminal (122a) and said second terminal (122b),
- corresponds to said value (MV) indicative of the voltage (V_{PYRO}) at said first terminal (122a) and said second terminal (122b) divided by a predetermined value (MI), or
- corresponds to said value (MV) indicative of the voltage (V_{PYRO}) at said first terminal (122a) and said second terminal (122b) divided by value (MI) indicative of said current (I_{PYRO}) provided via said first terminal (122a) and said second terminal (122b).

6. The deployment circuit according to any of the previous claims, wherein said at least one electronic switch (2002a) comprises an electronic switch (2002a) connected between said second terminal (122b) and said negative terminal (123), and said at least one current limiter (2000a) comprises a current limiter (2000a) connected between said positive terminal (121) and said first terminal (122a).

7. The deployment circuit according to Claim 6, comprising a current measurement circuit (206) configured to obtain a value (MI) indicative of the current (I_{PYRO}) flowing through said electronic switch (2002a) connected between said second terminal (122b) and said negative terminal (123).

8. The deployment circuit according to a combination of Claim 6 and Claim 7, wherein said electronic switch (2002a) connected between said second terminal (122b) and said negative terminal (123) is a n-channel FET, and wherein said current measurement circuit (206) comprises:
- a further n-channel FET (2064) having a gate terminal connected to a gate terminal of said n-channel FET (2002), which receives said deployment control signal (DEP_CMD);
- a regulator circuit (2066, 2068) configured to vary the current (I_{MON}) flowing through said further n-channel FET (2064) until the drain-source voltage of said further n-channel FET (2064) corresponds to the drain-source voltage of said further n-channel FET (2064);
wherein said current measurement circuit (206) is configured to obtain said value (MI) indicative of the current (I_{PYRO}) flowing through said electronic switch (2002a) by monitoring the current (I_{MON}) flowing through said further n-channel FET (2064).

9. The deployment circuit according to any of the previous claims, wherein said control circuit (202) is configured to:
- increase a count value (CNT) when the current (I_{PYRO}) provided via said first terminal (122a) and said second terminal (122b) is greater than said current threshold (I_{TH}) during said deployment cycle; and
- determine (1014) whether said monitored value (CNT) indicates that said time (t_{DEPLOY}) is greater than said time threshold (t_{TH}) by determining (1014) whether said count value (CNT) is greater than a count threshold (CNT_{TH}).

10. The deployment circuit according to any of the previous claims, wherein said control circuit (202) is configured to periodically repeat the following operations while said fire request signal (REQ) is de-asserted:
- obtain (1002) said first value (MR) indicative of said resistance (R_{PYRO}) between said first terminal (122a) and said second terminal (122b);
- determine (1004) whether said first value (MR) is between a first threshold and a second threshold, and
- in response to determining that said first value (MR) is not between said first threshold and said second threshold, signal (1016) an error.

11. The deployment circuit according to any of the previous claims, wherein said first threshold corresponds to a minimum resistance value of a correctly connected undeployed pyrotechnic device (101), said second threshold corresponds to a maximum resistance value of a correctly connected undeployed pyrotechnic device (101) and said third threshold corresponds to a minimum resistance value of a correctly connected deployed pyrotechnic device (101).

12. An integrated circuit comprising a deployment circuit (100) according to any of the previous claims.

13. A vehicle comprising a deployment circuit (100) according to any of the previous claims 1 to 11.

14. A method of operating a deployment circuit (100) according to any of the previous claims, comprising:
- starting said deployment circuit (20) while said fire request signal (REQ) is de-asserted, whereby said control circuit (202):
- obtains (1002) the first value (MR) indicative of a resistance (R_{PYRO}) between said first terminal (122a) and said second terminal (122b);
- determines (1004) whether said first value (MR) is between a first threshold and a second threshold, and
- in response to determining that said first value (MR) is not between said first threshold and said second threshold, signals (1016) an error;
- asserting said fire request signal (REQ), whereby said control circuit (202):
- starts (1006) a deployment cycle by setting said maximum value (IMAX) to a first value (I_{DEP}) and asserting said deployment control signal (DEP_CMD),
- stops (1010) said deployment cycle after a given time period (t_{DC}) by de-asserting said deployment control signal (DEP_CMD),
- monitors (1008) during said deployment cycle a value (CNT) indicative of the time (t_{DEPLOY}) where the current (I_{PYRO}) provided via said first terminal (122a) and said second terminal (122b) is greater than a current threshold (I_{TH}),
- once said deployment cycle has been stopped, obtains (1012) a second value (MR) indicative of a resistance (R_{PYRO}) between said first terminal (122a) and said second terminal (122b),
- determines (1014) whether said monitored value (CNT) indicates that said time (t_{DEPLOY}) is greater than said time threshold (t_{TH}) and whether said second value (MR) is greater than said third threshold, and
- in response to determining that said monitored value (CNT) indicates that said time (t_{DEPLOY}) is greater than said time threshold (t_{TH}) and said second value (MR) is greater than said third threshold, signals a correct deployment of said pyrotechnic device (101).
